# EUROPÄISCHE PATENTANMELDUNG

(11) **EP 1 909 334 A1**
(43) Veröffentlichungstag der Anmeldung: **09.04.2008**
(21) Anmeldenummer: 06121892.1
(22) Anmeldetag: 06.10.2006
(51) Int. Cl.: H01L 31/048

(54) **Verfahren und Folienverbund zum Kontaktieren und Abdichten eines Solarmoduls**

(71) Anmelder: Schreiner Group GmbH & Co. KG, 85764 Oberschleissheim (DE)
(72) Erfinder: Schirdewahn, Bernhard, 85386, Eching (DE); Schlarb, Andreas, 80993, München (DE); Wechselberger, Dietmar, 84144, Geisenhausen (DE); Forster, Johannes, 82256, Fürstenfeldbruck (DE); Horn, Thomas, 80937, München (DE)
(74) Vertreter: Ettmayr, Andreas

(57) **Zusammenfassung**

Auf einer Trägerscheibe (3) sind die abzudichtenden und an ihren Enden (5) zu kontaktierenden Solarzellensträrige (4) angeordnet. In der unterseitigen Klebstoffschicht (6) des Folienverbunds (1) sind Zonen mit elektrisch leitendem Klebstoff (7) vorgesehen, welche mit den Enden (5) der Solarzellenstränge (4) verklebt werden. Die Zonen mit elektrisch leitendem Klebstoff (7) sind von elektrisch nichtleitendem Klebstoff (8) umgeben, welcher zur Abdichtung der Solarzellenstränge (4) dient. Der Folienverbund (1) enthält eine elektrisch leitende Leitschicht (9), welche mit den Zonen elektrisch leitenden Klebstoffs (7) der Klebstoffschicht (6) in Verbindung steht. Außerhalb der Zonen elektrisch leitenden Klebstoffs (7) ist die Leitschicht (9) nach unten zu durch den nichtleitenden Klebstoff (8) der Klebstoffschicht (6) isoliert. Zusätzlich kann eine isolierende Folie (11) als Durchschlagschutz vorgesehen sein. Die Leitschicht (9) ist in zwei voneinander getrennte Bereiche aufgeteilt, um die getrennte Kontaktierung der beiden Pole des Solarelements zu ermöglichen. Das Abgreifen der elektrischen Spannung zwischen den beiden Bereiche der Leitschicht (9) von außen erfolgt durch zwei Durchgänge (12).

## Beschreibung

Die vorliegende Erfindung betrifft ein Verfahren und einen Folienverbund zum Kontaktieren und Abdichten eines Solarmoduls, ferner ein Solarmodul, welches mit einem entsprechenden Folienverbund bzw. nach einem entsprechenden Verfahren kontaktiert und abgedichtet ist. Insbesondere betrifft die Erfindung ein Verfahren zum Kontaktieren und Abdichten eines Solarmoduls, wobei zunächst ein Trägerverbund des Solarmoduls vorliegt, welcher einen Träger, mindestens eine abzudichtende Solarzelle sowie mindestens zwei zu kontaktierende Stellen aufweist.

Als Solarmodule bezeichnet man in der Photovoltaik eingehauste Einheiten mit mindestens einer, in der Regel jedoch mehreren, (meist gruppenweise) miteinander verschalteten Solarzellen zur Umwandlung von Strahlungsenergie in elektrische Energie. Solarmodule werden einzeln oder zu mehreren betrieben und können sowohl zur Energieversorgung bestimmter Objekte, wie etwa Wetterstationen, Verkehrseinrichtungen oder Campinganhängern wie auch zur Netzeinspeisung in größeren Anlagen betrieben werden.

Ein Solarmodul ist stets als Verbund aus mehreren Materialien und Bauteilen aufgebaut. Der Verbund muß dabei Schutz der (meist spröden) Solarzellen vor mechanischer Beschädigung, einen Berührschutz stromführender Teile und - da Solarmodule fast immer im Freien montiert sind - einen Schutz gegen Witterungseinflüsse, insbesondere eine Abdichtung gegen eindringende Feuchtigkeit bieten.

Ferner müssen Solarmodule geeignete Anschlußmöglichkeiten zum Abgreifen der erzeugten Spannung bieten. Meist sind Solarmodule zudem mit geeigneten Befestigungshilfen, wie etwa Einbaurahmen, Halterungsschienen und dergleichen ausgestattet.

Die verschiedenen Bauformen umfassen laminierte Glas-Glas-Module und Glas-Glas-Module in Gießharztechnik, nachfolgend werden jedoch vor allem Module mit Glasträger und rückseitiger Folienabdichtung sowie folienartige Dünnschichtmodule betrachtet.

Gängige Module weisen eine vorderseitige, d.h. im Betrieb der Lichteinstrahlung zugewandte Glasscheibe als Träger auf, auf welchem mono- oder polykristalline Solarzellen oder auch Solarzellen aus amorphem Silizium (sogenannte AS-Zellen) angeordnet sind, welche in eine transparente Kunststoffschicht, z.B. aus Ethylen-Vinylacetat (EVA) eingebettet sein können. Die Solarzellen können durch Flachleiter, insbesondere Lötbändchen oder auch über Halbleiterkontakte miteinander verschaltet sein. Rückseitig besteht eine Abdichtung mittels einer witterungsbeständigen Kunststofffolie, beispielsweise aus Polyvinylfluorid und Polyester. Der gesamte Verbund ist meist mit einem Rahmen, beispielsweise aus Aluminium oder geeigneten Kunststoffen zum Schutz der Glasscheibe bei Transport und Montage, sowie zur Montage (siehe oben) eingefaßt.

Bei herkömmlichen Verfahren der eingangs genannten Art wird der Trägerverbund meist mit dem (Glas-)Träger und somit in der Regel optisch aktiven Seite nach unten vorgelegt. Die auf dem Träger angeordneten Solarzellen sind in der Regel zu einem oder mehreren Strängen verbunden. Die Enden der Stränge müssen entweder einzeln, oder, wenn sie über Querverbinder miteinander verbunden sind, an einer (für jeden Pol) gemeinsamen Stelle kontaktiert werden, um den späteren Anschluß zum Abgreifen der Spannung zu ermöglichen. Die Kontaktierung erfolgt in der Regel über eine Lötverbindung. Die Solarzellen werden mit Schmelzklebeschichten (meist auf Basis von EVA-Polymeren) versiegelt. Zur vollständigen Abdichtung und zur Erzielung eines hinreichenden mechanischen Schutzes wird eine Schutzfolie bzw. ein, oft aluminiumhaltiger, Folienverbund mit Hilfe einer EVA-Klebeschicht angebracht. Dabei wird ein Verbakkungsprozeß bei 150 bis 220 Grad Celsius ausgeführt.

Derartige Verfahren haben den Nachteil, daß sie zum einen viel Handarbeit erfordern, zum anderen aufgrund des Verbackungsprozesses zeit- und energieaufwendig sind.

Vor dem Hintergrund der geschilderten Problematik ist es Aufgabe der vorliegenden Erfindung, die Kontaktierung und Abdichtung von Solarmodulen mit einem höheren Automatisierungsgrad, kürzeren Taktzeiten in der Herstellung und niedrigerem Energieverbrauch ermöglichen.

Gemäß einem Aspekt der vorliegenden Erfindung wird diese Aufgabe durch ein Verfahren der eingangs genannten Art gelöst, welches wie folgt abläuft: Es wird ein Folienverbund bereitgestellt, welcher eine isolierende Schutzfolie, eine in mindestens zwei voneinander getrennten Teilflächen auf der Schutzfolie angeordnete Leitschicht und eine die Leitschicht auf deren der Schutzfolie abgewandten Seite überdeckende Klebstoffschicht mit mindestens zwei, in Kontakt mit je mindestens einer der Teilflächen der Leitschicht stehenden, elektrisch leitenden Klebstoffzonen und mindestens einer elektrisch nichtleitenden Klebstoffzone aufweist. Auf einen Trägerverbund des Solarmoduls, welcher einen Träger, mindestens eine abzudichtende Solarzelle sowie mindestens zwei zu kontaktierende Stellen aufweist, wird der Folienverbund mittels der Klebstoffschicht aufgebracht, wobei die elektrisch leitenden Klebstoffzonen in Berührung mit den zu kontaktierenden Stellen des Trägerverbunds kommen und die mindestens eine abzudichtende Solarzelle vollständig von der Klebstoffschicht bedeckt wird.

Gemäß einem weiteren Aspekt der vorliegenden Erfindung wird diese Aufgabe durch einen Folienverbund gelöst, welcher eine isolierende Schutzfolie, eine in mindestens zwei voneinander getrennten Teilflächen auf der Schutzfolie angeordnete Leitschicht und eine die Leitschicht auf deren der Schutzfolie abgewandten Seite überdeckende Klebstoffschicht mit mindestens zwei, in Kontakt mit je mindestens einer der Teilflächen der Leitschicht stehenden, elektrisch leitenden Klebstoffzonen und mindestens einer elektrisch nichtleitenden Klebstoffzone aufweist.

Gemäß einem weiteren Aspekt der Erfindung wird die zugrundeliegende Aufgabe durch ein Solarmodul gelöst, aufweisend einen Trägerverbund, welcher einen, vorzugsweise Einscheibensicherheitsglas aufweisenden, Träger mindestens eine Solarzelle sowie mindestens zwei Kontaktstellen umfaßt, sowie einen Folienverbund, welcher eine isolierende Schutzfolie, eine in mindestens zwei voneinander getrennten Teilflächen auf der Schutzfolie angeordnete Leitschicht und eine die Leitschicht auf deren der Schutzfolie abgewandten und dem Trägerverbund zugewandten Seite überdeckende Klebstoffschicht mit mindestens zwei elektrisch leitenden Klebstoffzonen und mindestens einer elektrisch nichtleitenden Klebstoffzone aufweist, wobei die elektrisch leitenden Klebstoffzonen in Berührung mit den Kontaktstellen des Trägerverbunds stehen und die mindestens eine Solarzelle vollständig von der Klebstoffschicht bedeckt ist.

Erfindungsgemäß kann das Abdichten der Solarzellen mittels der Klebstoffschicht sowie das Kontaktieren mittels elektrisch leitender Klebstoffzonen in einem gemeinsamen, gut automatisierbaren Schritt erfolgen. Eine Verbackung bei hohen Temperaturen ist nicht mehr erforderlich. Vorzugsweise findet das gesamte erfindungsgemäße Verfahren bei Temperaturen unter 120 Grad Celsius, besonders bevorzugt bei gewöhnlicher Umgebungstemperatur zwischen 10 und 30 Grad Celsius, insbesondere jedoch Raumtemperatur statt. Allerdings kann auch der Einsatz eines Hotmelts oder bei erhöhten Temperaturen aushärtenden Klebers in der Klebstoffschicht bei der Umsetzung der vorliegenden Erfindung vorteilhaft sein. Aufgrund der Kontaktierung mittels elektrisch leitenden Klebstoffs können Lötarbeiten entfallen. Insbesondere die Kontaktstellen des Trägerverbunds werden lötfrei kontaktiert.

In der Regel wird der Folienverbund rückseitig, d.h. auf der im Betrieb vom Hauptlichteinfall abgewandten Seite aufgebracht. Insbesondere bei der Herstellung dünnschichtiger Module kann es jedoch auch vorteilhaft sein, den Folienverbund (teil-)transparent auszuführen und das Modul so zu gestalten, daß der Folienverbund auf der Wirkseite, d.h. der im Betrieb dem Hauptlichteinfall zugewandten Seite angeordnet ist. Im Außeneinsatz ist Witterungs- und UV-Beständigkeit der Schutzfolie erforderlich. Dies ist mit gängigen Folienmaterialien wie z.B. Polyethylen, Polyester, Polyvinylchlord , Polytetrafluorethylen erreichbar.

Je nach Anwendungsfall besonders gut geeignete Klebstoffe sind nachfolgend aufgeführt. Hierzu gehören Haftklebstoffe auf Acrylat- oder auch Kautschukbasis. Als Acrylate kommen Dispersions-, Lösemittel- oder UV-vernetzte Acrylate in modifizierter oder reiner Form in Frage. Unter dem Aspekt hoher Langzeitstabilität, insbesondere auch UV-Stabilität und Temperaturstabilität sind vor allem UV-vernetzte Acrylate oder reine Lösemittelacrylate besonders gut geeignet. Darüberhinaus können jedoch auch andere Klebstoffe vorteilhaft sein. Ein weiteres Kriterium zur Klebstoffauswahl ist die Langzeitverträglichkeit mit den Materialien, welche mit dem Klebstoff in Kontakt stehen. Dieses Kriterium wird von den obigen Klebstoffen in der Regel erfüllt. Gemäß einer vorteilhaften Ausgestaltung können die elektrisch leitenden Klebstoffzonen mit einem anisotrop leitenden Klebstoff, oft als "Z-Kleber" bezeichnet, ausgestattet sein, so daß die Leitfähigkeit in Richtung von der kontaktierten Stelle des Trägerverbunds zur Leitschicht höher ist, als senkrecht hierzu. Gemäß einer besonders vorteilhaften Weiterbildung können die elektrisch leitenden Klebstoffzonen aus einem leitfähigen, vorzugsweise anisotrop leitenden, Transferkleber gebildet sein.

Vorzugsweise wird der Folienverbund als durchgehende Bahn zur Abdichtung und Kontaktierung mehrerer Solarmodule bereitgestellt. Besonders bevorzugt liegen die Solarmodule nach Aufbringen des Folienverbundes zunächst zusammenhängend vor und werden dann voneinander getrennt, d.h. der Folienverbund wird auf nebeneinander angeordnete bzw. seriell zugeführte Trägerverbünde aufgebracht und anschließend etwa durch Schneiden oder Stanzen durchtrennt. Möglich ist es auch, einen durchgehenden Trägerverbund vorzulegen, welcher ebenfalls im Rahmen des Trennvorgangs in den entstehenden Solarmodulen zugeordnete Abschnitte aufgeteilt wird.

Gemäß einer besonders bevorzugten Ausgestaltungsform der Erfindung weist die Schutzfolie Durchgänge im Bereich mindestens zweier Teilflächen der Leitschicht auf. Diese Durchgänge können als freie Öffnungen ausgeführt oder mit leitendem Material (z.B. einem leitenden Polymer, einem geeigneten Lot, einer Leitpaste oder dergleichen mehr) gefüllt sein.

Vorteilhafterweise können sich die Teilflächen der Leitschicht sich über einen überwiegenden Flächenanteil der Schutzfolie erstrecken, wodurch die Leitfähigkeit in der Folienebene höher ist, als wenn die Leitschicht in Form schmaler Leiterbahnen ausgeführt wird.

Zur Verringerung der Durchschlaggefahr kann vorteilhafterweise im Bereich der elektrisch nichtleitenden Klebstoffzone(n) eine isolierende Folienlage zwischen der Klebstoffschicht und der Leitschicht angeordnet sein.

Gemäß einer besonders bevorzugten Ausführungsform ist die klebstoffseitige Oberfläche des Folienverbunds durch Pressen (etwa mittels Preßwalzen oder durch hydrostatisches Pressen) eingeebnet. Eine, insbesondere auch am Übergang zwischen elektrisch leitenden und nichtleitenden Klebstoffzonen, ebene Oberfläche der Klebstoffschicht vereinfacht das Aufbringen des Folienverbunds ohne unerwünschte Lufteinschlüsse.

Je nach Anforderungen im Einzelfall kann die Schutzfolie mehrlagig ausgeführt sein und beispielsweise reflektierende, wärmeisolierende, UV-filternde, chemisch hochstabile, mit bestimmten mechanischen Eigenschaft ausgestattete oder anderweitig für die erwarteten Einsatzbedingungen besonders geeignete Materialien umfassen.

In dem Trägerverbund muß kein Glasträger vorgesehen sein, auch ausgehend von einem dünnschichtigen Träger ist die Erfindung vorteilhaft umsetzbar.

Grundsätzlich kann jede im Rahmen der vorliegenden Anmeldung beschriebene bzw. angedeutete Variante der Erfindung besonders vorteilhaft sein, je nach wirtschaftlichen und technischen Bedingungen im Einzelfall. Soweit nichts gegenteiliges dargelegt ist, bzw. soweit grundsätzlich technisch realisierbar, sind einzelne Merkmale der beschriebenen Ausführungsformen austauschbar oder miteinander sowie auch mit aus dem Stand der Technik per se bekannten Maßnahmen kombinierbar.

Nachfolgend werden anhand der zugehörigen Zeichnungen Beispiele bevorzugter Ausführungsformen der vorliegenden Erfindung näher erläutert. Die Zeichnungen sind dabei rein schematische und, aus Gründen der Anschaulichkeit, nicht maßstäbliche Darstellungen. Insbesondere können Verhältnisse der Abmessungen zueinander von tatsächlichen Ausführungen abweichen. So ist etwa die Dicke von Folienlagen stark übertrieben dargestellt.

Einander entsprechende Elemente sind in den einzelnen Figuren jeweils, soweit sinnvoll, mit den gleichen Bezugszeichen versehen.

Im einzelnen zeigen:
- Fig.1: eine Explosions-Zeichnung einer Ausführungsform eines erfindungsgemäßen Solarmoduls bestehend aus einem Trägerverbund und einem Folienverbund,
- Fig. 2a: den Folienverbund aus Fig. 1 in einer Querschnittansicht, wobei die Schnittebene in Fig. 1 durch punkt-strichlierte Linien angedeutet ist,
- Fig. 2b: den.Trägerverbund aus Fig. 1 in einer Querschnittansicht mit derselben Schnittebene,
- Fig. 2c: eine Querschnittansicht des zusammengefügten Solarmoduls aus Fig. 1, wiederum mit derselben Schnittebene wie in Figuren 2a und 2b,
- fig.3: eine Explosions-Zeichnung einer weiteren Ausführungsform eines erfindungsgemäßen Solarmoduls ähnlich Fig. 1
- Fig. 4: den Folienverbund des Solarmoduls aus Fig. 3 in einer Querschnittansicht, wobei die Schnittebene in Fig. 3 durch punkt-strichlierte Linien angedeutet ist,
- Fig. 5a: einen Ausschnitt des Schichtaufbaus einer Ausführungsform eines erfindungsgemäßen Folienverbunds ähnlich Fig. 4 während dessen Herstellung, und
- Fig. 5b: denselben Ausschnitt wie Fig. 5a nach einem Preßvorgang.

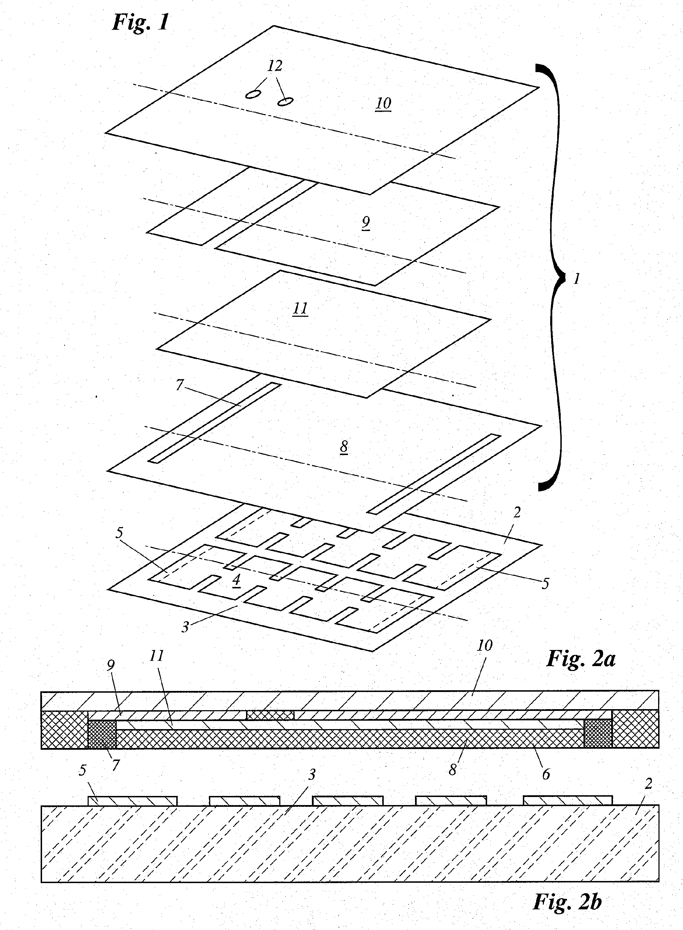

Die Explosionszeichnung in Fig. 1 zeigt einen erfindungsgemäßen Folienverbund 1 und einen Trägerverbund 2, welche nach dem erfindungsgemäßen Verfahren zu einem erfindungsgemäßen Solarmodul zusammengefügt sind. Letzteres ist in Fig. 2c im Querschnitt dargestellt. Die strichpunktierten Linien in Fig. 1 deuten dabei die Schnittebene an. Figuren 2a und 2b zeigen Folienverbund 1 bzw. Trägerverbund 2 vor dem Zusammenfügen.

Auf einer Trägerscheibe 3 aus Einscheibensicherheitsglas sind die abzudichtenden und zu kontaktierenden Solarzellenstränge 4 angeordnet. Die Kontaktierung hat dabei an den als Kontaktstellen ausgebildeten Enden 5 zu erfolgen.

In der unterseitigen Klebstoffschicht 6 des Folienverbunds 1 sind Zonen mit elektrisch leitendem Klebstoff 7 vorgesehen, welche zum Kontaktieren mit den Enden 5 der Solarzellenstränge 4 verklebt werden. Auch lediglich schwach adhesive leitende Pasten sollen hier noch als elektrisch leitender Klebstoff 7 augefaßt werden. Die Zonen mit elektrisch leitendem Klebstoff 7 sind von elektrisch nichtleitendem Klebstoff 8 umgeben, welcher zur Abdichtung der Solarzellenstränge 4 dient.

Der Folienverbund 1 enthält eine elektrisch leitende Leitschicht 9, welche mit den Zonen elektrisch leitenden Klebstoffs 7 der Klebstoffschicht 6 in Verbindung steht. Die Leitschicht 9 kann vorteilhafterweise aus einer Metallfolie, beispielsweise einer, ggf. verzinnten, Kupferfolie oder Aluminiumfolie, bestehen oder auch drucktechnisch auf die Schutzfolie 10 aufgebracht sein. Nicht dargestellt ist eine, je nach Ausführung der Schutzfolie 10 und der Leitschicht 9, unter Umständen vorzusehende Verbindungsschicht (beispielsweise aus einem Klebstoff oder Haftvermittler) zur Verbindung der beiden Schichten 9, 10 miteinander.

Außerhalb der Zonen elektrisch leitenden Klebstoffs 7 ist die Leitschicht 9 nach unten zu durch den nichtleitenden Klebstoff 8 der Klebstoffschicht 6 isoliert. Zusätzlich kann eine isolierende Folie 11 als Durchschlagschutz vorgesehen sein. Wiederum nicht dargestellt ist eine, je nach Ausführung der isolierenden Folie 11 und der Leitschicht 9, unter Umständen vorzusehende Verbindungsschicht (beispielsweise aus einem Klebstoff oder Haftvermittler) zur Verbindung der beiden Schichten 9, 11 miteinander.

Die Leitschicht 9 ist in zwei voneinander getrennte Bereiche aufgeteilt, um die getrennte Kontaktierung der beiden Pole des Solarelements zu ermöglichen und einen Kurzschluß zu vermeiden. In dem dargestellten Beispiel übernimmt die Leitschicht 9 zudem noch die Aufgabe einer Querverbindung zwischen den parallelgeschalteten Solarzellensträngen 4.

Das Abgreifen der elektrischen Spannung zwischen den beiden Bereiche der Leitschicht 9 von außen erfolgt durch zwei Durchgänge (z.B. Öffnungen) 12.

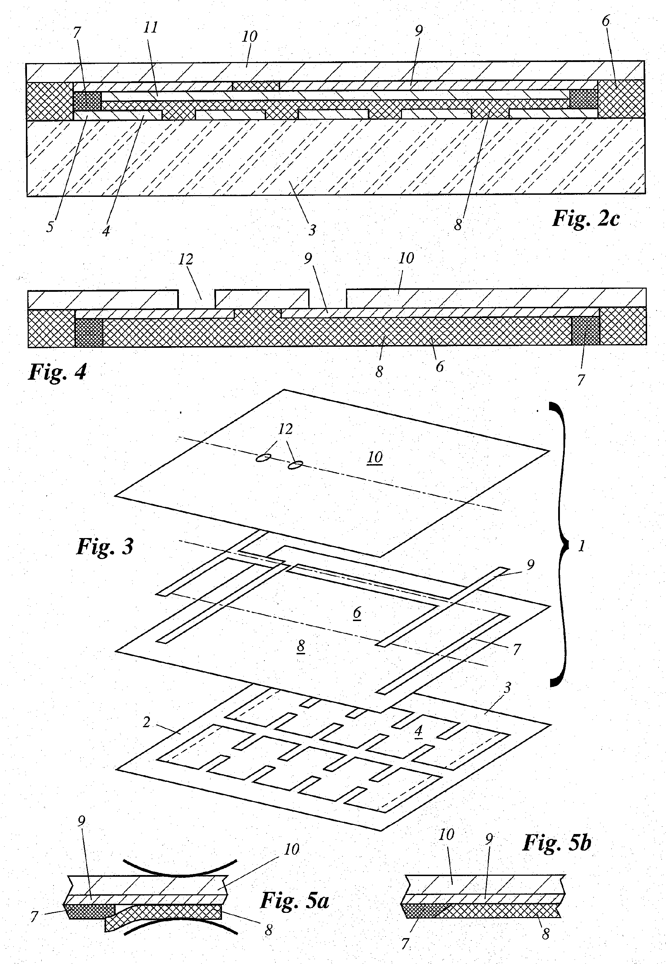

Fig. 3 zeigt, ähnlich wie Fig. 1, einen erfindungsgemäßen Folienverbund 1 und einen Trägerverbund 2, welche nach dem erfindungsgemäßen Verfahren zu einem erfindungsgemäßen Solarmodul zusammengefügt sind. Fig. 4 zeigt einen Querschnitt durch den Folienverbund 1 aus Fig. 3, wobei die strichpunktierten Linien in Fig. 3 die Schnittebene andeuten.

Der Aufbau entspricht weitgehend dem in Figuren 1-2c dargestellten Aufbau, allerdings ist kein zusätzlicher Durchschlagschutz vorgesehen, und die Leitschicht 9 ist in Form schmaler Leiterbahnen ausgeführt.

Je nach Anwendungszweck sind auch Ausführungen des Folienverbunds 1 mit mehreren übereinander angeordneten und lokal miteinander in Verbindung stehenden unterbrochenen Leitschichten 9 möglich, etwa um ein Array einzelner Solarzellen oder von Solarzellengruppen über Quer- und Längsverbindungen miteinander zu verschalten.

Wie bereits erwähnt, kann das Zusammenfügen des Folienverbunds 1 mit dem Trägerverbund 2 leicht automatisiert werden, wobei man sich bekannter Vorrichtungen aus dem Gebiet der Laminiertechnik bedienen kann. Beim Zusammenfügen wird in einem Verfahrensschritt die Kontaktierung der Kontaktstellen 5, ohne daß hierfür ein Lötvergang erforderlich wäre, und die Abdichtung der Solarzellen 4 bewerkstelligt.

Um Lufteinschlüsse beim Zusammenfügen zu vermeiden, können, neben einer sorgfältigen Führung des Folienverbunds 1, verschiedene Maßnahmen vorteilhaft sein, beispielsweise das Zusammenlaminieren im Vakuum oder unter einer geeigneten Flüssigkeit (etwa einem ein- oder mehrwertigen Alkohol).

Wesentlich erhöhen läßt sich die Sicherheit gegen unerwünschte Lufteinschlüsse durch eine unterseitig möglichst eben ausgeführte Klebstoffschicht 6, wobei ein besonderes Augenmerk dem bündigen und ebenen Übergang zwischen dem elektrisch leitenden Klebstoff 7 und dem elektrisch nichtleitenden Klebstoff 8 gilt. Dies läßt sich beispielsweise durch Verpressen des Folienverbunds 1; etwa im Walzenspalt oder durch hydrostatisches Pressen erreichen.

In Fig. 5a angedeutet sind überlappende Zonen von elektrisch leitendem Klebstoff 7 und elektrisch nichtleitendem Klebstoff 8 an einem ausschnittsweise dargestellten Folienverbund 1 mit Schutzfolie 10 und Leitschicht 9. Mit höherer Strichstärke angedeutet ist ein Walzenspalt, durch welchen der Folienverbund 1 von links nach rechts in Fig. 5a gezogen wird. Fig. 5b zeigt den eingeebneten Übergang zwischen dem elektrisch leitenden Klebstoff 7 und dem elektrisch nichtleitenden Klebstoff 8 nach dem Verpressen.

## Patentansprüche

1. Verfahren zum Kontaktieren und Abdichten eines Solarmoduls, wobei
(a) ein Trägerverbund (2) des Solarmoduls vorliegt, welcher einen Träger (3), mindestens eine abzudichtende Solarzelle (4) sowie mindestens zwei zu kontaktierende Stellen (5) aufweist,
(b) ein Folienverbund (1) bereitgestellt wird, welcher
- eine isolierende Schutzfolie (10),
- eine in mindestens zwei voneinander getrennten Teilflächen auf der Schutzfolie (10) angeordnete Leitschicht (9) und
- eine die Leitschicht (9) auf deren der Schutzfolie (10) abgewandten Seite überdeckende Klebstoffschicht (6) mit mindestens zwei, in Kontakt mit je mindestens einer der Teilflächen der Leitschicht (9) stehenden, elektrisch leitenden Klebstoffzonen (7) und mindestens einer elektrisch nichtleitenden Klebstoffzone (8)
aufweist, und
(c) der Folienverbund (1) mittels der Klebstoffschicht (6) so auf den Trägerverbund (2) aufgebracht wird, daß
- die elektrisch leitenden Klebstoffzonen (7) in Berührung mit den zu kontaktierenden Stellen des Trägerverbunds (2) kommen und
- die mindestens eine abzudichtende Solarzelle (4) vollständig von der Klebstoffschicht (6) bedeckt wird.

2. Verfahren gemäß Anspruch 1, wobei das Aufbringen des Folienverbundes (1) maschinell erfolgt.

3. Verfahren gemäß einem der vorangehenden Ansprüche, wobei ein Folienverbund (1) bereitgestellt wird, dessen Schutzfolie (10) Durchgänge (12) im Bereich mindestens zweier Teilflächen der Leitschicht (9) aufweist, und wobei nach dem Aufbringen des Folienverbundes (1) Anschlußmittel befestigt und durch die Durchgänge mit der Leitschicht (9) verbunden werden.

4. Verfahren gemäß einem der vorangehenden Ansprüche, wobei der Folienverbund (1) als durchgehende Bahn zur Abdichtung und Kontaktierung mehrerer Solarmodule bereitgestellt wird.

5. Verfahren gemäß Anspruch 4, wobei die Solarmodule nach Aufbringen des Folienverbundes (1) zunächst zusammenhängend vorliegen und dann voneinander getrennt werden.

6. Folienverbund (1) zum Kontaktieren und Abdichten eines Solarmoduls, aufweisend
- eine isolierende Schutzfolie (10);
- eine in mindestens zwei voneinander getrennten Teilflächen auf der Schutzfolie (10) angeordnete Leitschicht (9) und
- eine die Leitschicht (9) auf deren der Schutzfolie (10) abgewandten Seite überdeckende Klebstoffschicht (6) mit mindestens zwei, in Kontakt mit je mindestens einer der Teilflächen der Leitschicht (9) stehenden, elektrisch leitenden Klebstoffzonen (7) und mindestens einer elektrisch nichtleitenden Klebstoffzone (8).

7. Folienverbund (1) gemäß Anspruch 6, wobei die Schutzfolie (10) Durchgänge im Bereich mindestens zweier Teilflächen der Leitschicht (9) aufweist.

8. Folienverbund (1) gemäß einem der Ansprüche 6-7, wobei die elektrisch leitenden Klebstoffzonen (7) mit einem anisotrop leitenden Klebstoff ausgestattet sind.

9. Folienverbund (1) gemäß einem der Ansprüche 6-8, wobei die Teilflächen der Leitschicht (9) sich über einen überwiegenden Flächenanteil der Schutzfolie (10) erstrecken.

10. Folienverbund (1) gemäß einem der Ansprüche 6-9, wobei die klebstoffseitige Oberfläche des Folienverbunds (1) durch Pressen eingeebnet ist.

11. Folienverbund (1) gemäß einem der Ansprüche 6-10, wobei im Bereich mindestens einer elektrisch nichtleitenden Klebstoffzone (8) eine isolierende Folienlage (11) zwischen der Klebstoffschicht (6) und der Leitschicht (9) angeordnet ist.

12. Folienverbund (1) gemäß einem der Ansprüche 6-11 , welcher zumindest teiltransparent ausgeführt ist.

13. Folienverbund (1) gemäß einem der Ansprüche 6-12, wobei die Schutzfolie (10) mindestens zweilagig ausgeführt ist.

14. Solarmodul, auweisend
(a) einen Trägerverbund (2), welcher einen Träger (3), mindestens eine Solarzelle (4) sowie mindestens zwei Kontaktstellen aufweist,
(b) einen Folienverbund (1), welcher
- eine isolierende Schutzfolie (10),
- eine in mindestens zwei voneinander getrennten Teilflächen auf der Schutzfolie (10) angeordnete Leitschicht (9) und
- eine die Leitschicht (9) auf deren der Schutzfolie (10) abgewandten und dem Trägerverbund (2) zugewandten Seite überdeckende Klebstoffschicht (6) mit mindestens zwei elektrisch leitenden Klebstoffzonen (7) und mindestens einer elektrisch nichtleitenden Klebstoffzone (8)
wobei die elektrisch leitenden Klebstoffzonen (7) in Berührung mit den Kontaktstellen des Trägerverbunds (2) stehen und die mindestens eine Solarzelle (4) vollständig von der Klebstofschicht bedeckt ist.

15. Solarmodul gemäß Anspruch 14, wobei die Schutzfolie (10) Durchgänge (12) im Bereich mindestens zweier Teilflächen der Leitschicht (9) aufweist.

16. Solarmodul gemäß einem der Ansprüche 14-15, wobei die elektrisch leitenden Klebstoffzonen (7) mit einem anisotrop leitenden Klebstoff ausgestattet sind.

17. Solarmodul gemäß einem der Ansprüche 14-16, wobei die Teilflächen der Leitschicht (9) sich über einen überwiegenden Flächenanteil des Solarmoduls erstrecken.

18. Solarmodul gemäß einem der Ansprüche 14-17, wobei im Bereich mindestens einer elektrisch nichtleitenden Klebstoffzone (8) eine isolierende Folienlage (11) zwischen der Klebstoffschicht (6) und der Leitschicht (9) angeordnet ist.

19. Solarmodul gemäß einem der Ansprüche 14-18, wobei der Folienverbund (1) zumindest teiltransparent ausgeführt und auf der im Betrieb sonnenzugewandten Seite angeordnet ist.

20. Solarmodul gemäß einem der Ansprüche 14-19, wobei der Träger (3) Einscheibensicherheitsglas aufweist.

21. Solarmodul gemäß einem der Ansprüche 14-20, welches mindestens zwei in Serie geschaltete Solarzellen (4) aufweist.

22. Solarmodul gemäß einem der Ansprüche 14-21, wobei es sich bei der mindestens einen Solarzelle (4) um eine AS-Solarzelle handelt.

23. Solarmodul gemäß einem der Ansprüche 14-22, wobei die Schutzfolie (10) mindestens zweilagig ausgeführt ist.
